(19) Europäisches Patentamt
European Patent Office
Office européen des brevets

(11) Veröffentlichungsnummer: **0 439 843 A1**

(12) **EUROPÄISCHE PATENTANMELDUNG**

(21) Anmeldenummer: **90125839.2**

(51) Int. Cl.5: **C08J 3/24**, C09K 5/04

(22) Anmeldetag: **31.12.90**

(30) Priorität: **25.01.90 DE 4002107**

(43) Veröffentlichungstag der Anmeldung: **07.08.91 Patentblatt 91/32**

(84) Benannte Vertragsstaaten: **BE DE DK ES FR GB IT NL**

(71) Anmelder: **HOECHST AKTIENGESELLSCHAFT**
**Postfach 80 03 20**
**W-6230 Frankfurt am Main 80(DE)**

(72) Erfinder: **Naumann, Joachim**
**Im Schulzehnten 16**
**W-6233 Kelkheim/Taunus(DE)**
Erfinder: **Schmelzer, Heinz**
**Schlossbergstrasse 15**
**W-6531 Rümmelsheim(DE)**

(54) **Verfahren zum Härten von heisshärtbaren Präpolymeren.**

(57) Die Erfindung betrifft ein Verfahren zum Härten von heißhärtbaren Präpolymeren, bei dem man die Präpolymeren mit einem Härter mischt und dann mit dem heißen Dampf eines Perfluorpolyethers der allgemeinen Formel I

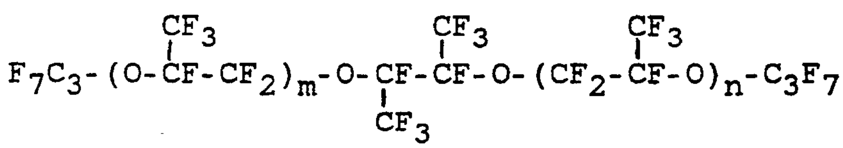

wobei m und n ganze Zahlen von 0 bis 3 sind, in Berührung bringt, wobei der Dampf mindestens die Temperatur hat, die für die Härtung des eingesetzten Präpolymeren notwendig ist.

EP 0 439 843 A1

## VERFAHREN ZUM HÄRTEN VON HEISSHÄRTBAREN PRÄPOLYMEREN

Duroplaste oder duroplastische Kunststoffe sind Kunststoffe, die irreversibel ausgehärtet sind. Sie sind starr und auch bei hohen Temperaturen nicht verformbar.

Duroplaste entstehen durch Vernetzung bestimmter niedermolekularer Vorprodukte, sogenannter Präpolymerer, mit einem Härter. Man unterscheidet Ein- und Zweikomponenten-Systeme, je nachdem ob Präpolymeres und Härter bereits längere Zeit vor der Härtung gemischt und bis zum Härtevorgang in Form einer einzigen Komponente aufbewahrt werden können oder ob sie bis zum Härtevorgang in Form von zwei getrennten Komponenten aufbewahrt werden müssen. Bei den Zweikomponenten-Systemen werden Präpolymeres und Härter (Vernetzer) erst direkt vor dem gewünschten Beginn der Härtung miteinander vermischt und dann bei Raumtemperatur vernetzt (ausgehärtet). Bei den Einkomponenten-Systemen reagieren Präpolymeres und Härter dagegen erst bei erhöhter Temperatur; die dabei verwendeten Präpolymeren werden daher als "heißhärtbare Präpolymere" bezeichnet.

Die Einkomponenten-Duroplaste werden z.B. als Klebstoffe oder Beschichtungen verwendet. Einkomponenten-Klebstoffsysteme können z.B. auf Epoxid-, Polyurethan- oder Acrylatbasis hergestellt werden (Wagner-Sarx: "Lackkunstharze" (1959) S. 154-157; Patrick: "Treatise on Adhesion and Adhesives" (1969) Vol. 2, Chapter 2.5 "Chemistry and Mechanism of the Cure Process", Chapter 2.6A "Commercial Epoxid Resins", Chapter 2.6B "Curing Agents"; Lee and Neville: "Handbook of Epoxid Resins" (1982) Chapter 1: Epoxid Resins, Chapter 5: Curing; EP 0 046 941).

Nach herkömmlichen Verfahren werden Einkomponenten-Duroplaste häufig durch Erwärmung unter IR-Bestrahlung auf Temperaturen von 120°C bis 200°C und/oder durch UV-Bestrahlung ausgehärtet. Die Wärmebehandlung ist relativ zeitaufwendig und dauert 5 bis 30 Minuten. Das zweite Verfahren, die UV-Bestrahlung, setzt den Zusatz von UV-Sensibilisatoren voraus und hat den Nachteil, daß die UV-Strahlen die zu klebenden Teile - wenn diese kompliziert aufgebaut sind - nicht überall mit der gleichen Intensität erreichen (Schattenbildung). Deswegen wird die UV-Bestrahlung oft nur in Kombination mit einer Wärmebehandlung (1. Fixierung des Klebers durch UV-Bestrahlung, 2. Härtung durch Wärmeeinwirkung = IR-Bestrahlung) angewendet.

Aus der US-PS 4 721 578 ist ein Verfahren zur Wärmeübertragung auf Werkstücke bekannt, welches auch das Härten von heißhärtbaren Präpolymeren umfaßt, bei dem die Werkstücke mit dem heißen Dampf eines perfluorierten Hexafluorpropenoxid-Oligomeren der Formel

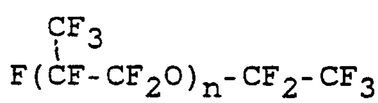

mit n = 1-9 in Kontakt gebracht werden.

Gegenstand der Erfindung ist ein Verfahren zum Härten von heißhärtbaren Präpolymeren, dadurch gekennzeichnet, daß man die Präpolymeren mit einem Härter mischt und dann mit dem heißen Dampf eines Perfluorpolyethers der allgemeinen Formel I

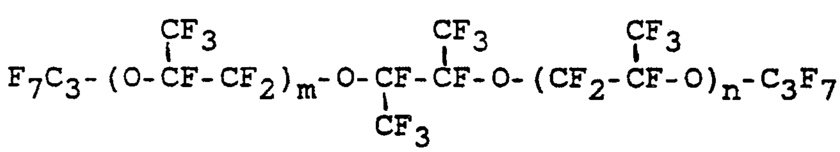

wobei m und n ganze Zahlen von 0 bis 3 sind, in Berührung bringt, wobei der Dampf mindestens die Temperatur hat, die für die Härtung des eingesetzten Präpolymeren notwendig ist. Vorzugsweise sind m und n ganze Zahlen von 0 bis 2.

Es können alle üblichen Einkomponenten-Systeme aus Präpolymerem und Härter eingesetzt werden.

Vorzugsweise arbeitet man mit dem Dampf eines siedenden Perfluorpolyethers der Formel I, dessen Siedetemperatur mindestens den Wert hat, der für die Härtung des eingesetzten Präpolymeren notwendig ist. Die Siedetemperatur des ausgewählten Perfluorpolyethers kann auch einen höheren Wert haben als für den Härtungsprozeß notwendig ist, jedoch bedeutet dies im allgemeinen einen überflüssigen Energieaufwand. Daher benutzt man in einer besonders bevorzugten Ausführungsform der Erfindung den Dampf

desjenigen siedenden Perfluorpolyethers der Formel I, dessen Siedetemperatur mindestens den für die Härtung notwendigen Wert hat und außerdem diesem notwendigen Wert am nächsten kommt, d.h. möglichst wenig über diesem liegt.

Das Härten von Einkomponenten-Duroplasten in der Dampfphase eines der genannten Perfluorpolyether ist eine Art Reflow-Technik mit kontinuierlicher Wärmezufuhr (vgl. Lea and Johns, Brazing and Soldering, No. 12, Spring 1987, S. 34-39). Die latente Verdampfungswärme dieser Perfluorpolyether wird verwendet, um viskose Präpolymere, vorzugsweise beim Siedepunkt des eingesetzten Perfluorpolyethers, zu vernetzen, d.h. auszuhärten, z.B. um SMD-Teile (Surface Mounted Devices) mit einem Ein-Komponentenkleber auf Epoxidharzbasis auf einer Leiterplatte zu fixieren (Bucher, Elektronik 7/31.03.1988, S. 108-113). Ausreichende Mengen eines solchen Klebstoffes werden durch ein Sieb oder durch eine geätzte Metallschablone oder mit einem Dispenser auf die miteinander zu verklebenden Stellen appliziert und wenn nötig vorgetrocknet, falls der Klebstoff ein schwer flüchtiges Lösemittel enthält. In den meisten Fällen ist jedoch bei dem Verfahren mit den erfindungsgemäßen Perfluorpolyethern eine Vortrocknung nicht erforderlich. Anschließend werden die zu verklebenden Bauteile in eine Zone mit heißem Dampf eines der genannten Perfluorpolyether eingetaucht. Der Dampf kondensiert auf den relativ kalten Oberflächen der eingetauchten Teile.

Dabei wird die Verdampfungswärme des Perfluorpolyethers frei, der viskose Klebstoff wird vernetzt, ausgehärtet und die Teile an der Klebstelle fixiert. Wenn man dieses Verfahren mit siedendem Perfluorpolyether durchführt, ist die Dampftemperatur gleich der Siedetemperatur des gewählten Perfluorpolyethers. Die erfindungsgemäßen Perfluorpolyether haben als Substanzen einheitlicher molekularer Zusammensetzung und hoher Reinheit einen konstanten Siedepunkt und garantieren so eine präzise Temperaturkontrolle bei einem solchen Klebeprozeß. Die Perfluorpolyether-Dämpfe verteilen sich schnell über die Flächen der zu verklebenden Bauteile, unabhängig von deren Konstruktion. Die Aushärtung des Klebstoffes dauert nur wenige Sekunden. Das bedeutet im Vergleich zu den konventionellen Verfahren mit Infrarot- oder Ultraviolett-Bestrahlung eine erhebliche Zeiteinsparung. Dieses Dampfphase-Verfahren vollzieht sich in einer nahezu luftfreien Umgebung, so daß Luftfeuchtigkeit von den Klebstoffen nicht absorbiert werden kann. Luftfeuchtigkeit kann nämlich die vollständige Aushärtung behindern. Ein weiterer Vorteil der Perfluorpolyether besteht darin, daß sie - im Gegensatz zu vielen anderen organischen Flüssigkeiten - wegen ihres inerten Verhaltens weder Kunststoffe noch Metalle angreifen.

Sowohl nach dem Batch-Prinzip arbeitende Standgeräte als auch Continue-Inline-Anlagen sind einsetzbar, wie sie beim Dampfphase-Löten bekannt sind (Bucher, Elektronik 7/31.03.1988, S. 108-113; Merkblatt Hoechst AG "Hostinert", Ausgabe Oktober 1989). Bei dem diskontinuierlichen Batch-Verfahren wird oft außer einem der genannten Perfluorpolyether (Primärmedium) eine obere Sperrschicht, bestehend aus dem Dampf einer Fluorverbindung (Sekundärmedium), z.B. Trichlortrifluorethan verwendet, wobei der Siedepunkt des Sekundärmediums deutlich unter dem des Primärmediums (Perfluorpolyether) liegt, um dessen Verdunstung zu verhindern. Die kontinuierlich arbeitenden und transportierenden Inline-Anlagen können in einen total automatisierten Produktionsprozeß integriert werden und sind für einen größeren Leistungsausstoß gedacht. Eine Dampfphase aus einem Sekundärmedium ist bei diesen Anlagen nicht notwendig.

**Beispiel 1**

Vier Epoxidharzplatten wurden mit Aceton entfettet. Auf den Rand von zwei Platten mit den Abmessungen von 25 x 105 mm wurde jeweils ein pastöser, lösemittelfreier Einkomponenten-Klebstoff auf Epoxidharzbasis vom Typ I (Harzkomponente auf Basis Epichlorhydrin und Bisphenol A, Härterkomponente auf Basis eines Anhydrids) bzw. vom Typ II (thixotropierter Epoxidharzklebstoff mit ebenfalls bereits beigemischtem gleichem Härter) in einer Breite von 5 mm aufgetragen und jeweils eine weitere Platte auf die Klebefläche unter leichtem Druck angelegt. Anschließend wurden die beiden Plattenpaare in dem Korb eines nach dem Batch-Prinzip arbeitenden Standgerätes gelegt und mit dem Korb durch die obere Sperrschicht des Sekundärdampfes (Trichlortrifluorethan) in die Dampfphase eines siedenden Perfluorpolyethers (Primärmedium) mit der Strukturformel

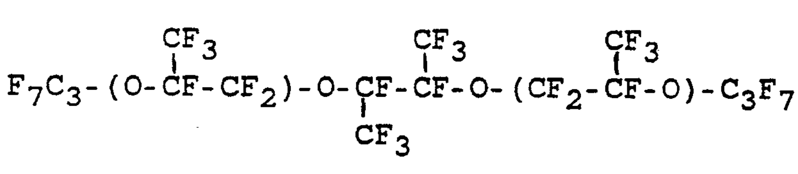

d.h. Formel I mit m = 1 und n = 1, mit einem Siedepunkt von 216 °C eingetaucht. Die zu verklebenden Teile verweilten dort 20 Sekunden bei einer Temperatur, die dem Siedepunkt des Primärmediums entsprach. Danach wurde der Korb mit den verklebten Teilen in die Sekundärdampfzone mit einer Temperatur von ca. 150 °C hochgezogen. Die Verweildauer betrug 50 Sekunden. Anschließend wurden die Teile in dem Korb aus dem Schacht der Anlage transportiert und herausgenommen. Um festzustellen, ob das Epoxidharz vernetzt worden war, wurde die Haftung der beiden Verklebungen nach DIN 53 283 "Bestimmung der Bindefestigkeit von einschnittig überlappten Klebungen im Zugversuch" bei Raumtemperatur geprüft. Die Bindefestigkeit betrug beim Klebstoff Typ I 15,0 $N/mm^2$ und bei Klebstoff Typ II 13,6 $N/mm^2$. Damit wurde nachgewiesen, daß die erforderliche Klebfestigkeit erreicht wurde. Während beim konventionellen Heißhärten Vernetzungszeiten von 15 Minuten bei 150 °C, bzw. 5 bis 10 Minuten bei 180 °C, notwendig sind, dauerte der Aushärteprozeß nach dem Verfahren mit dem obigen Perfluorpolyether weniger als zwei Minuten.

**Beispiel 2**

Dieses Beispiel zeigt die Verklebung von Folien mit einem heiß vernetzbaren Haftklebstoff auf Acrylatbasis. Verwendet wurde ein in Ethylacetat gelöster Acrylatklebstoff, dessen Harzkomponente aus einem Reinacrylattyp (Copolymerisat von Acrylsäureestern) und dessen Härter aus einem Metallchelat (Al-Butylat) bestand. Der Arbeitsvorgang verlief in der gleichen Reihenfolge wie beim Beispiel 1, nur wurde als Primärmedium die Dampfphase des siedenden Perfluorpolyethers mit der Strukturformel

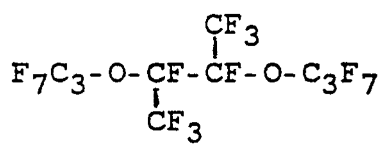

d.h. Formel I mit m = 0 und n = 0, mit einem Siedepunkt von 130 °C ausgewählt. Die Temperatur der Primärdampfzone betrug demnach 130 °C, die der Sekundärdampfzone etwa 65 °C. Die zu verklebenden Folien verweilten in der Primärdampfzone 25 Sekunden. Die Haftung der Verklebung wurde nach PSTC (Pressure Sensitive Tape Council, Glenview, Illinois, USA) 7 auf einer Fläche von 1,5 x 1,5 cm mit einem Gewicht von 1 kg bei Raumtemperatur geprüft. Die Zeit der Abschälung lag zwischen vier und sechs Stunden. Die Zeit der Abschälung liegt bei unbehandelten Haftklebungen dieser Art dagegen zwischen ein und zwei Stunden. Damit war nachgewiesen, daß der Haftklebstoff ausreichend vernetzt war. Der Aushärteprozeß dauerte nur etwa zwei Minuten. Die verklebten Polyesterfolien waren nicht geschrumpft und hatten sich im Aussehen nicht verändert. Dagegen wird die Vernetzung bei konventionellen Verfahren erst nach zehn bis fünfzehn Minuten bei 150 °C erreicht.

**Beispiel 3**

Zur Prüfung der Adhäsion der erfindungsgemäßen Perfluorpolyether an Kunststoffsubstraten sowie der Beständigkeit von Epoxidharzplatten in den Perfluorpolyethern wurden folgende Versuche durchgeführt: Je zwei Epoxidharzplatten wurden 10 mal jeweils 60 Sekunden lang in die Dampfphase des siedenden Perfluorpolyethers mit der Strukturformel

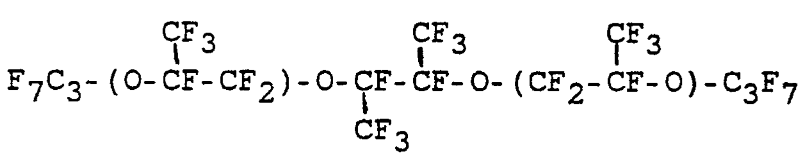

d.h. Formel I mit m = 1 und n = 1, mit einem Siedepunkt von 216 °C eingetaucht. Dasselbe wurde wiederholt unter Einsatz eines Perfluorpolyethers der Formel

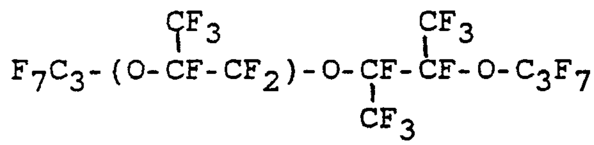

d.h. Formel I mit m = 1 und n = 0, mit einem Siedepunkt von 175 °C. Es wurde geprüft, ob sich die behandelten Epoxidharzplatten im Aussehen, in den Maßen und im Gewicht verändert hatten. Die Platten hatten sich bei der zehnmaligen Behandlung in den beiden Perfluorpolyether-Dampfphasen nur leicht verfärbt, sich in den Maßen aber nicht verändert. Es trat also keine Quellung auf. Der Gewichtsverlust betrug bei 216 °C 1 % und bei 175 °C 0,5 %. Da die Behandlung bei beiden Versuchen etwa fünf Mal länger als ein Aushärtevorgang eines Klebeprozesses dauerte, kann man davon ausgehen, daß die Kunststoffsubstrate erst recht während eines Klebeprozesses unverändert bleiben würden. Die Gewichtsabnahmen beweisen außerdem, daß keine Reste der Perfluorpolyether auf solchen Kunststoffsubstraten zurückbleiben, die deren Qualität bei einer Verklebung mit Hilfe der Polyether beeinträchtigen könnten.

**Beispiel 4**

Zur Prüfung der Beständigkeit von Metallen in den erfindungsgemäßen Perfluorpolyethern wurde mit Aluminium (99,5 Masse-% Al), Kupfer (99,5 - 99,8 Masse-% Cu) und den zwei Edelstahlsorten (Werkstoff Nr. 1.4541 und 1.4571 nach DIN 17 440) Heißkorrosionstests von 40 Stunden nach DIN 50 906 "Korrosionsprüfung in kochenden Flüssigkeiten" in dem in Beispiel 3 verwendeten Perfluorpolyether mit einem Siedepunkt von 216 °C durchgeführt und nach DIN 50 905 "Chemische Korrosionsuntersuchungen", Blatt 2, ausgewertet. Der Massenverlust lag bei allen Metallen sowohl in der Flüssigals auch in der Dampfphase deutlich unter 0,1 mg/cm$^2$. Lediglich bei Kupfer war der Massenverlust in der Dampfphase geringfügig höher (0,15 mg/cm$^2$). Die behandelten Metalle hatten sich im Aussehen nicht verändert. Aufgrund dieser Versuchsergebnisse, die unter extremen Bedingungen zustande kamen, kann eine Korrosion beim Verkleben von Metallen derartiger Qualitäten ausgeschlossen werden.

**Patentansprüche**

1. Verfahren zum Härten von heißhärtbaren Präpolymeren, dadurch gekennzeichnet, daß man die Präpolymeren mit einem Härter mischt und dann mit dem heißen Dampf eines Perfluorpolyethers der allgemeinen Formel I

   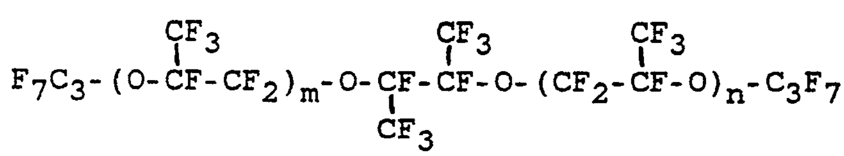

   wobei m und n ganze Zahlen von 0 bis 3 sind, in Berührung bringt, wobei der Dampf mindestens die Temperatur hat, die für die Härtung des eingesetzten Präpolymeren notwendig ist.

2. Verfahren nach Anspruch 1, dadurch gekennzeichnet, daß man mit dem Dampf eines siedenden Perfluorpolyethers arbeitet, dessen Siedetemperatur mindestens den Wert hat, der für die Härtung des eingesetzten Präpolymeren notwendig ist.

3. Verfahren nach Anspruch 2, dadurch gekennzeichnet, daß man mit dem Dampf desjenigen Perfluorpolyethers arbeitet, dessen Siedetemperatur der für die Härtung des eingesetzten Präpolymeren notwendigen Temperatur am nächsten kommt.

Europäisches Patentamt

# EUROPÄISCHER RECHERCHENBERICHT

Nummer der Anmeldung

**EP 90 12 5839**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 106 754 (F. LAMBERT et al.)<br>* Insgesamt *<br>– – – | 1-3 | C<br>08 J 3/24<br>C 09 K 5/04 |
| Y | EP-A-0 287 398 (AUSIMONT S.p.A.)<br>* Ansprüche 1,2,5; Seite 2, Zeilen 21-45; Seite 3, Zeilen 47-50 *<br>– – – – – | 1-3 | |
| | | | **RECHERCHIERTE SACHGEBIETE (Int. Cl.5)** |
| | | | C 08 J<br>C 09 K<br>C 08 G |

Der vorliegende Recherchenbericht wurde für alle Patentansprüche erstellt

| Recherchenort | Abschlußdatum der Recherche | Prüfer |
|---|---|---|
| Den Haag | 22 Mai 91 | HALLEMEESCH A.D. |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze

E: älteres Patentdokument, das jedoch erst am oder nach dem Anmeldedatum veröffentlicht worden ist
D: in der Anmeldung angeführtes Dokument
L: aus anderen Gründen angeführtes Dokument

&: Mitglied der gleichen Patentfamilie, übereinstimmendes Dokument